Europäisches Patentamt

European Patent Office

Office européen des brevets

(19)

(11) **EP 1 033 812 B1**

(12) **EUROPEAN PATENT SPECIFICATION**

(45) Date of publication and mention
of the grant of the patent:
**10.08.2005 Bulletin 2005/32**

(51) Int Cl.⁷: **H03H 17/06**

(21) Application number: **99830112.1**

(22) Date of filing: **03.03.1999**

(54) **Oversampling structure with frequency response of the sinc type**

Struktur zur Überabtastung mit sinc-förmigem Frequenzgang

Structure de suréchantillonnage ayant une réponse en fréquence du type sinc

(84) Designated Contracting States:
**DE FR GB IT**

(43) Date of publication of application:
**06.09.2000 Bulletin 2000/36**

(73) Proprietor: **STMicroelectronics S.r.l.**
**20041 Agrate Brianza (Milano) (IT)**

(72) Inventors:
• **Ferri, Simone**
**26865 S. Rocco al Porto (IT)**
• **Molinari, Luca**
**29100 Piacenza (IT)**
• **Bianchessi, Marco**
**20061 Melzo (IT)**

(74) Representative: **Pellegri, Alberto et al**
**c/o Società Italiana Brevetti S.p.A.**
**Piazza Repubblica, 5**
**21100 Varese (IT)**

(56) References cited:
**US-A- 5 835 390**

• **HOGENAUER E B: "AN ECONOMICAL CLASS
OF DIGITAL FILTERS FOR DECIMATION AND
INTERPOLATION" IEEE TRANSACTIONS ON
ACOUSTICS, SPEECH AND SIGNAL
PROCESSING, vol. 29, no. 2, 1 April 1981
(1981-04-01), pages 155-162, XP000560569**

**Description**

Whenever is required, an oversampling of a digital signal, for example in sigma-delta ($\Sigma$-$\Delta$) *D/A* converters, the problem arises to implement such an oversampling operation with integrated structures the more compact as possible to reduce as much as possible the area requisite.

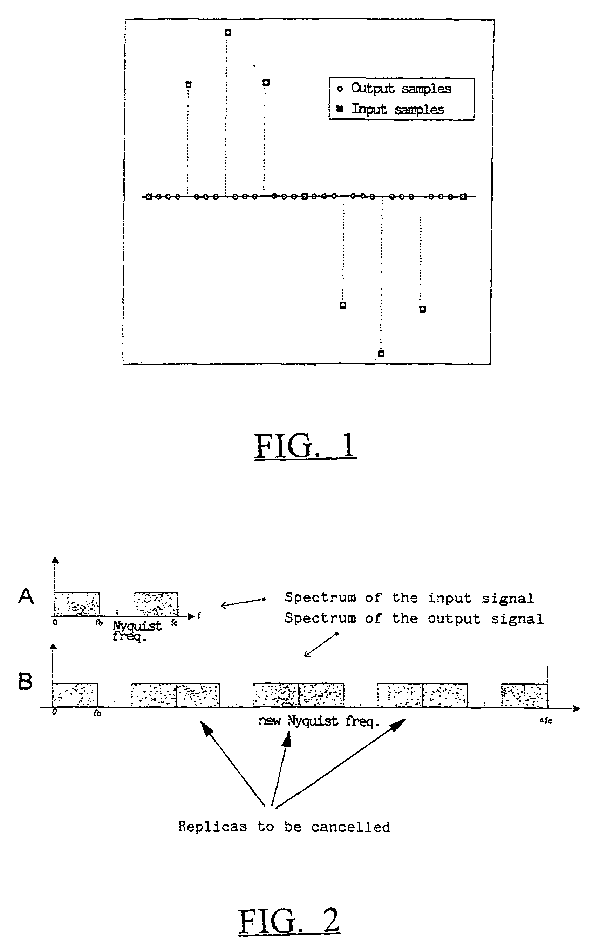

The oversampling operation is commonly effected by inserting *N* null samples between two successive samples of the input signal ($N^{th}$ order oversampling), as depicted in Fig. 1.

In this way undesired replicas of the signal spectrum are generated (Fig. 2): the objective is to filter them.

At the end of these operations a signal interpolation is realized. When referring to interpolating stages in the ensuing description, it is intended that circuit structures that perform a zero insertion as well as the filtering of the replicas create the spectrum of the input signal.

The requirements of the filtering operation relate to the attenuation of the replicas. This attenuation should be as strong as possible, without adversely affecting the constancy of the frequency response of the filter in the signal band (ideally the gain variation of the filter throughout the signal band should be null). The more the above reported ideal conditions are complied with, the more the filter is considered "accurate".

DISCUSSION OF THE PRIOR ART

The interpolators that are currently used for this purpose are complete FIR filters (often of the half-band type), linear interpolators and sample&hold structures.

The so-called FIR filters are filters with their own coefficients and require the use of RAM cells, ROM, adders and, often, multipliers. The results obtained in terms of attenuation and precision of the frequency response are excellent, though the occupation of silicon area may become relatively large.

By way of comparison, linear interpolators and "sample&hold" (SH) are much simpler to realize and, for the same oversampling order, occupy a smaller silicon area than FIR. This has a price in terms of a lesser attenuation of the spectrum replicas as well as of an undesired attenuation of the base band signal.

Both linear interpolators and sample&hold circuits have a frequency response, *H(f)*, of the sinc$^k$ type, where *k* is equal to 2 and 1, respectively, (*k=0* coinciding to an insertion of zeroes without any successive filtering).

*H(f)* is more generally quantified by the following expression:

$$H(f) = \frac{\sin \left( \pi * f / f_{in} \right)^{k}}{\sin \left( \pi * f / (N * f_{in}) \right)^{k}}$$

Specially, in low cost applications, it would be generally advisable to have structures capable of implementing interpolations of a higher order than the first or the second, even accepting a slight attenuation of the base band signal, while preserving simplicity and architectural compactness.

The US patent No. 5,835,390 discloses a digital filter for achieving substantial attenuation of aliasing or imaging bands of a signal to be filtered.

PURPOSE AND SUMMARY OF THE INVENTION

The purpose of the present invention is to provide an architecture of oversampling, filtering and reconstructing of a digital signal for any order of oversampling fulfilling the above mentioned requisites.

The invention is defined in the appended independent claim.

Substantially, the structure of the present invention consists of a chain of derivators and integrators separated by a sampler, which holds the information.

The architecture of the invention presents an impulse response of limited duration and amplitude. Thanks to the use of a sample&hold stage rather than a zero insertion technique it is possible to realize the structure with a sinc$^k$ type transfer function, that is of a *k* order, by employing a *k-1* number of derivators and an equal number of integrators. The effect of the derivators is to perform a low frequency filtering, while retaining in the output signal the necessary information to describe the filtered data. The bit growth for the derivation part of the input signal occurs on a bit per stage basis by performing a subtraction at the output of each derivator stage such as to bring to a maximum growth of a single bit.

Substantially, from the input to the output of the architecture of the invention, the digital signal is amplified by an $N^k$ factor (where *N* represents the clock frequency), which is equivalent to an increment of *k\*log2 (N)* bits.

The integrators have a divergent gain at low frequencies and present limited and quantifiable output values. By suitably designing the integrators, the overflow may be averted and so the errors that may occur therefrom.

Qualitatively, these advantageous characteristics depend on the derivators behavior, which though tending to annul the low frequency components of the signal, they preserve at their output the necessary information for a correct signal reconstruction. The sample&hold stage broadens the band and effects a first filtering action of the spectrum replicas and a first reconditioning of the signal in base band. These operations are then repeated *k-1* times by the integrator stages of the second chain that follows the sample&hold stage causing a filtering of the desired frequency response as final result.

The oversampling architecture of the invention also comprises auxiliary by-pass means, for the exceptional case for example in presence of metastability events, the maximum stage dynamics being exceeded, such as to provide for a momentary by-pass of the oversampling architecture of the invention and for the reset of all the stages.

## BRIEF DESCRIPTION OF THE DRAWINGS

Figures **1** and **2** show the oversampling scheme by way of the introduction of a certain number of null samples and signal interpolation, according to a known approach.

Figure **3** is a diagram of the architecture of the present invention.

Figure **4** is the frequency response diagram of a third order filter realized according to the present invention.

Figure **5** shows an alternative embodiment of the architecture of the invention.

## DESCRIPTION OF FEW EMBODIMENTS OF THE INVENTION

In the basic architectural scheme of oversampling, filtering and signal reconstruction of the present invention, *G* indicates the quantity *log2(N)* that may be defined as the growth or gain of interpolation, as it depends only on the oversampling factor *N*.

*B* is the number of bits of the input signal.

By way of simplicity, are defined as correspondents that is having an identical number of bits, the first derivator and the last integrator, the second derivator and the second last integrator, and so forth.

The operating frequency *1/T* and *T/N* (where *T* is the clock period) of the different blocks is indicated in the illustrations.

The integrators function at a frequency *N* times higher than that of the derivators and the task of the sample&hold block is to retain the input datum for *N* clock pulses.

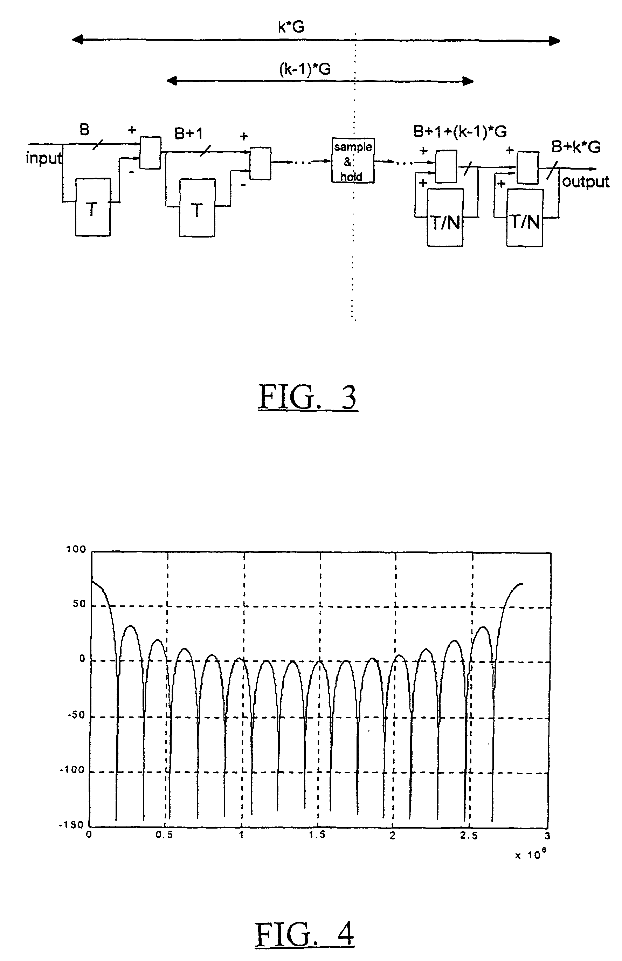

The transfer function of the circuit of Fig. 3 may be obtained by observing that the sample&hold has a behavior that in the domain of the Z transform is described by:

$$S(z)=(1-z^{-1})/(1-z^{-1/N}).$$

With this premise, it may be observed that there are *k-1* derivators in cascade: $D(z)=(1-z^{-1})^{k-1}$ and *k-1* integrators in cascade: $I(z)=1/(1-z^{-1/N})^{k-1}$. Thus, the whole transfer function is:

$$H(z) = \left(\left(1 - z^{-1}\right)/\left(1 - z^{-1/N}\right)\right)^k$$

this function may be rewritten in the frequency domain:

$$H(f) = \frac{\sin{(\pi * f / f_{in})}^k}{\sin{(\pi * f / (N * f_{in}))}^k}$$

It should be also noticed the increment of the number of bits necessary to make up for the signal amplification of the circuit portion between the first and the second extremities of the arcs of the characteristic of frequency response.

The whole structure presents an impulse response of limited duration and amplitude.

Thanks to the use of a sample&hold block rather than a zeroes insertion technique, it is possible to realize a structure with a $sinc^k$ type transfer function, that is, of the $k^{th}$ order, with *k-1* derivators and *k-1* integrators.

It should be noticed that the growth of the number of bits of the derivation portion of the circuit occurs on a bit per stage basis, in fact at the output of each derivator a subtraction is performed and this type of operation may bring to the maximum growth of one bit. The net effect of the derivators is that of performing a low frequency filtering, ensuring retention in the output signal of the information required for describing the filtered data.

The signal between the input and the output is amplified by an $N^k$ factor (equal to *H(0)*) equivalent to an increment of *k\*log2 (N)* bits.

These affirmations descend from the analysis of the transfer function and are general, the same reasoning may be repeated for example by starting from the input of the second derivator and arriving to the second last integrator. The architecture remains substantially identical to that of the preceding case though there is one integrator and one derivator less than in the preceding case. In this case, the transfer function is:

$$H_1(f) = \frac{\sin{(\pi * f / f_{in})}^{k-1}}{\sin{(\pi * f / (N * f_{in}))}^{k-1}}$$

in consideration of the fact that between the input and the output there are *k-1* derivations and *k-1* integrations.

The new input-to-output gain has a maximum value of $N^{k-1}$ (equal to *H1(0)*) that in terms of increment of the number of bits is equivalent to *(k-1)\*G* additional bits, thus from the *N+1* bits input to the second derivator we arrive at *B+1+(k-1)\*G* bits output from the second last integrator.

A similar analysis may be undertaken even for the innermost pairs of derivator-integrator.

It may be demonstrated that for the correct calculation of the signal amplitude output by an integrator, the procedure is that of referring to the derivator associated to it and of incrementing the number of bits of the latter by an amount equal to $(k-i)*G$; where $i$ is the position of the derivator (equal to $1$ for the first, $k-1$ for the last): the whole number of bits output by any of the integrators of the chain is: $(k-i)*G+B+i$.

An advantage of the structure is that the integrators, having a divergent gain at low frequencies, present limited output values, quantifiable with the relationships described above. By suitably designing the integrators with these specifications, overflow may be avoided and so the errors that would derive from it.

Qualitatively, this descends from the behavior of the derivators which, while tending to annul the low frequency components of the signal, they still output the necessary information for a correct signal reconstruction.

The sample&hold stage broadens the band, performs a first filtering of the replicas of the spectrum of the signal and a first reconditioning of the signal in the base band. These two operations are repeated $k-1$ times by the integrators of the second chain and the final result is an effective filtering with a filter having a frequency response equal to the $H(f)$.

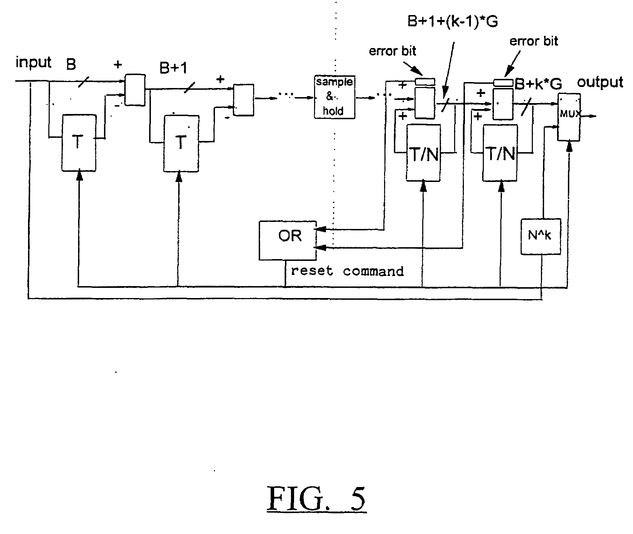

Fig. 4 illustrates the frequency response of a third order filter made according to the invention for oversampling from $44100*4Hz$ to $44100*128Hz.$

We may notice the "holes" in correspondence of the replicas of the spectrum to be eliminated. In abscissa is the frequency in $Hz$ and in ordinate the amplitude in $dB.$

While during correct operating conditions there may not be any problems, it is possible that errors may occur occasionally (caused for example by metastability phenomena) in the process stream leading to the final filtering.

According to a preferred embodiment of the architecture of the invention, in order to establish which outputs are affected by errors, an additional bit identifiable as "error bit", may be purposely inserted in the position that precedes the sign bit, in each integrator. The error bit of a stage is not passed to the following stage because it is not relevant to the processing but it only constitutes an updatable flag.

If, in case of exceptional events, the value of the stored data exceeds the maximum dynamics defined by the number of bits previously defined for each stage, the "error bit" reveals this anomaly and commands the reset of the data stored in the filter.

Naturally, under error conditions the filter's output is no longer valid and thus the filter structure is bypassed and the input datum is reproduced on the output, multiplied by $N^k$ in order to bring back the output dynamics to the same number of bits of the correct operation. The by-pass is effected along the parallel signal path through the multiplier stage and the multiplexer.

Being sufficient that only one of the error bit signals an error to cause the by-pass and the reset of the filter structure, the reset and the multiplexer (MUX) being controlled through a logic OR of the error bits, as shown in Fig. 5.

It may be observed how the multiplication is carried out by adding $k*G$ bits of zero value in the least significative positions (i.e. $1011 \Rightarrow 10110000$, if $k*G=4$), thereby without any need for additional logic circuitry.

The by-pass condition is momentary, lasting a time equal to $T*(k/N+k),$ which corresponds to the minimum time necessary for loading the data in the filter.

## Claims

1. An oversampling architecture for interpolating, filtering and reconstructing a digital signal comprising a first chain of derivators receiving at an input of a first derivator of the chain said digital signal and composed of a number $k-1$ of derivators in cascade functioning at a certain clock frequency ($1/T$), the first derivator having a certain number of bits ($B$) and the derivators that follow having a number of bits incremented by a unit in respect to the number of bits of the derivator that precede it in said cascade; a second chain of the same number $k-1$ of integrators in cascade, functioning at a clock frequency $N$ times higher ($N/T$) than the clock frequency ($1/T$) of said derivators, the last integrator of the cascade having a number of bits equal to the number of bits ($B$) of the first derivator incremented by a factor equivalent to the order ($k$) of the filter multiplied by the interpolation gain ($G$), and the integrators that precede it have a number of bits gradually decremented by a quantity equal to the interpolation gain ($G$) in respect to the number of bits of the integrator that follows it in said cascades; a "sample&hold" circuit having an input coupled to the output of the last derivator of said first chain and an output coupled to the input of the first integrator of said second chain; the last integrator of said second chain outputting said oversampled, filtered and reconstructed signal,

   **characterized in that** it comprises means in each integrator of said second chain containing an error bit coupled to respective inputs of a logic OR gate commanding the reset of all said derivators and integrators, when one of said error bits assumes a certain logic value, and simultaneously effecting a momentary by-pass of the architecture along a signal path parallel to said chains and comprising a multiplier of the input signal by $N^k$ and an output multiplexer (MUX).

**Patentansprüche**

1. Überabtastungsarchitektur zur Interpolation, Filterung und Rekonstruktion eines Digitalsignals, die aufweist: eine erste Kette von Derivatoren, die an einem Eingang eines ersten Derivators der Kette das Digitalsignal empfangen und aus einer Anzahl k-1 von Derivatoren in Kaskade bestehen, die mit einer bestimmten Taktfrequenz (1/T) arbeiten, wobei der erste Derivator eine bestimmte Anzahl von Bits (B) aufweist und die Derivatoren, die folgen, eine Anzahl von Bits aufweisen, die um eine Einheit bezüglich der Anzahl der Bits des Derivators erhöht ist, die ihm in der Kaskade vorausgeht; eine zweite Kette derselben Anzahl k-1 von Integratoren in Kaskade, die mit einer Taktfrequenz arbeiten, die N-fach höher (N/T) als die Taktfrequenz (1/T) der Derivatoren ist, wobei der letzte Integrator der Kaskade eine Anzahl von Bits aufweist, die gleich der Anzahl von Bits (B) des ersten Derivators ist, die um einen Faktor erhöht ist, der gleich der Ordnung (k) des Filters multipliziert mit der Interpolationsverstärkung (G) ist, und die Integratoren, die ihm vorausgehen, eine Anzahl von Bits aufweisen, die allmählich mit einer Quantität, die gleich der Interpolationsverstärkung (G) ist, bezüglich der Anzahl von Bits des Integrators gesenkt wird, der ihm in der Kaskade folgt; eine "Abtast-Halte"- Schaltung, von der ein Eingang an den Ausgang des letzten Derivators der ersten Kette gekoppelt ist und ein Ausgang an den Eingang des ersten Integrators der zweiten Kette gekoppelt ist, wobei der letzte Integrator der zweiten Kette das überabgetastete, gefilterte und rekonstruierte Signal ausgibt, **dadurch gekennzeichnet, daß** sie Einrichtungen in jedem Integrator der zweiten Kette aufweist, die ein Fehlerbit enthalten, das an jeweilige Eingänge eines logischen ODER- Glieds gekoppelt ist, das das Rücksetzen aller Derivatoren und Integratoren befiehlt, wenn eines der Fehlerbits einen bestimmten logischen Wert annimmt, und gleichzeitig eine momentane Umgehung der Architektur längs eines Signalweges parallel zu den Ketten bewirkt, und einen Multiplizierer des Eingangssignals mit $N^k$ und einen Ausgangsmultiplexer (MUX) aufweist.

**Revendications**

1. Architecture de suréchantillonnage pour interpoler, filtrer et reconstituer un signal numérique comprenant une première chaîne de dérivateurs recevant à une entrée d'un premier dérivateur de la chaîne le signal numérique qui est constitué d'un nombre k-1 de dérivateurs en cascade fonctionnant à une certaine fréquence d'horloge (1/T), le premier dérivateur ayant un certain nombre de bits (B) et chaque dérivateur suivant ayant un nombre de bits incrémenté d'une unité par rapport au nombre de bits du dérivateur précédant dans la chaîne ; une seconde chaîne du même nombre k-1 d'intégrateurs en cascade fonctionnant à une fréquence d'horloge (N/T) N fois supérieure à la fréquence d'horloge (1/T) desdits dérivateurs, le dernier intégrateur de la chaîne ayant un nombre de bits égal au nombre de bits (B) du premier dérivateur incrémenté d'un facteur équivalent à l'ordre (k) du filtre multiplié par le gain d'interpolation (G), et chaque intégrateur précédent ayant un nombre de bits décrémenté d'une quantité égale au gain d'interpolation (G) par rapport au nombre de bits de l'intégrateur suivant dans la chaîne ; un circuit d'échantillonnage ayant une entrée couplée à la sortie du dernier dérivateur de la première chaîne et une sortie couplée à l'entrée du premier intégrateur de la seconde chaîne, le dernier intégrateur de la seconde chaîne fournissant le signal suréchantillonné, filtré et reconstitué ;

**caractérisé en ce qu'**il comprend des moyens dans chaque intégrateur dans la seconde chaîne contenant un bit d'erreur couplé aux entrées respectives d'une porte logique OU commandant la remise à zéro de tous les dérivateurs et intégrateurs quand l'un des bits d'erreur prend une certaine valeur logique et effectuant simultanément une dérivation momentanée de l'architecture selon un trajet de signal parallèle aux chaînes et comprenant un multiplieur du signal d'entrée par N* et un multiplexeur de sortie (MUX).

FIG. 1

FIG. 2

FIG. 3

FIG. 4

## FIG. 5